# FASCICULE DE BREVET EUROPEEN

(11) **EP 0 337 856 B1**
(45) Date de publication et mention de la délivrance du brevet: **12.01.1994**
(21) Numéro de dépôt: 89400950.5
(22) Date de dépôt: 06.04.1989
(51) Int. Cl.: H05K 7/14

(54) **Ensemble démontable de matériel électrique ou électronique comprenant un boîtier et son logement**
Lösbare Baugruppe für eine elektrische oder elektronische Anlage, bestehend aus einem Gehäuse und dessen Gestell
Dismountable asssembly for electrical or electronic equipment comprising a casing, and its housing

(30) Priorité: 11.04.1988 FR 8804757
(43) Date de publication de la demande: 18.10.1989
(73) Titulaire: DASSAULT AVIATION, F-75008 Paris (FR)
(72) Inventeur: Weiss, Jean, F-95100 Argenteuil (FR); Estival, René, F-92210 Saint Cloud (FR); Noble, Pascal, F-95600 Eaubonne (FR)
(74) Mandataire: Colas, Jean-Pierre

(56) Documents cités:
- EP-A- 0 101 204
- FR-A- 2 049 249
- US-A- 3 014 160

## Description

La présente invention est relative à un ensemble démontable de matériel électrique ou électronique, du type comprenant un boîtier, ou tiroir, et un logement apte à recevoir ledit boîtier, et communément appelé "rack".

L'installation de boîtier électronique à bord des avions, hélicoptères ou autres engins pose, de façon plus ou moins délicate, des problèmes d'encombrement, de manipulation, de mise en place puis de fixation ou de verrouillage. L'utilisateur demande à avoir des systèmes permettant un échange facile et rapide, tout en restant relativement robustes et économiques.

L'extraction d'un boîtier de son logement peut poser des problèmes, surtout lorsque celui-ci est lourd, et que la place disponible est mesurée. Outre le poids à surmonter, il est en effet généralement nécessaire d'exercer un effort important pour l'enfichage et le désenfichage de connecteurs électriques, et dont certains modèles de boîtiers possèdent de très nombreuses broches. On trouve, en plus, souvent, des joints d'étanchéité ou de protection mécanique ou servant de blindage électromagnétique qui obligent à des efforts supplémentaires pour l'introduction ou l'extraction du boîtier.

Il existe une quantité de systèmes pour réduire les efforts nécessaires : poignée à cames extractives, levier articulé avec écrou moleté, système comprenant une vis sans fin et une crémaillère. Un système de ce genre, connu du document FR-A-2 049 249, et qui est couramment utilisé, comporte, sur le boîtier, un support de verrou équipé d'une vis sans fin entraînée en rotation par un arbre terminé par un usinage six pans destiné à recevoir un outil de manoeuvre. Le logement destiné à recevoir le boîtier comporte une crémaillère qui sert à coopérer avec la vis sans fin. Cette crémaillère est liée à une glissière qui guide le boîtier lors de son introduction ou de son extraction dans le logement. Le boîtier porte, en outre, à l'opposé de la vis sans fin, sur son fond, une pièce de guidage qui coopère avec la glissière.

Pour verrouiller le boîtier une fois qu'il est en place, il est prévu des lames de ressort fixées au boîtier, et qui pénètrent dans les encoches d'une roue dentée solidaire de la vis sans fin. La forme et la disposition de ces ressorts sont telles que, lorsqu'on introduit l'outil pour faire tourner la vis sans fin, on écarte les lames de ressort desdites encoches, ce qui permet la rotation.

Ce système présente quelques inconvénients, dont le plus important résulte de l'encombrement de la pièce associée à la vis sans fin. Cette pièce pénètre à l'intérieur du boîtier et constitue une complication pour la réalisation de l'appareillage électrique ou électronique contenu dans ce boîtier, si l'on veut éviter une perte de place. En outre, elle est relativement lourde. Par ailleurs, le système de verrouillage constitué par des ressorts agissant sur une roue dentée peut être faussé accidentellement, ou par l'emploi d'un outil inadapté. En outre, la glissière solidaire de la crémaillère constitue un ensemble qui doit être usiné avec précision et est donc relativement coûteux.

La présente invention a pour but de fournir un dispositif amélioré, qui soit moins encombrant, de plus faible poids, et de fonctionnement plus sûr, tout en étant d'un prix de revient aussi bas que possible.

Pour obtenir ce résultat, la présente invention fournit un ensemble démontable de matériel électrique ou électronique comprenant :
- un boîtier contenant des équipements électriques ou électroniques,
- un logement apte à recevoir ledit boîtier et pourvu de glissières aptes à coopérer avec les pièces de guidage complémentaires portées par le boîtier pour l'introduction ou l'extraction de ce dernier,
- au moins un connecteur à fiches comprenant deux éléments prévus l'un sur le boîtier et l'autre sur le logement, et qui sont en connexion lorsque le boîtier est complètement engagé dans le logement,
- des organes de serrage et d'extraction aptes à permettre de déplacer le boîtier au voisinage de sa position d'engagement complet dans son logement, en surmontant les forces de frottement engendrées par le connecteur, ces organes de serrage et d'extraction comprenant une vis sans fin portée par le boîtier et une crémaillère correspondante portée par le logement, et
- des moyens pour bloquer la rotation de ladite vis sans fin et immobiliser ainsi le boîtier en position d'engagement complet,
ce dispositif ayant pour particularité que lesdites glissières portées par le logement sont indépendantes de la crémaillère et espacées de celle-ci, et les pièces de guidage complémentaires liées au boîtier sont espacées l'une de l'autre dans une direction perpendiculaire à la direction d'introduction ou d'extraction du boîtier.

De préférence, dans le cas usuel où le boîtier et son logement sont en forme de parallélipipède, les glissières ou les pièces de guidage sont situées à proximité des arêtes de la face du boîtier qui porte les moyens de serrage et d'extraction.

Avantageusement, il est prévu des moyens de guidage indépendants desdites glissières et pièces de guidage, ces moyens étant situés à proximité de la vis sans fin et de la crémaillère, et servant seulement à faciliter l'engagement de ces pièces entre-elles lorsque le boîtier parvient au voisinage de sa position d'engagement complet dans le logement.

Ces mesures permettent d'avoir des glissières et pièces de guidage plus légères, car elles supportent moins d'efforts du fait qu'elles sont écartées les unes des autres, et en même temps leur précision peut être moins grande, d'où un prix de revient moins élevé.

Avantageusement encore, en particulier du point de vue encombrement, lorsque la vis sans fin peut être entraînée en rotation par une tige pourvue d'une tête d'entraînement destinée à coopérer avec un outil, on prévoit que la vis sans fin est d'une seule pièce avec ladite tige et sa tête d'entraînement, et qu'elle est maintenue sur un support lié simplement au boîtier à l'aide de deux paliers dont l'un au moins est rapporté.

De préférence, ladite tige comporte des cannelures ou des crantages destinés à coopérer avec au moins une bille poussée par un ressort, ces cannelures ou crantages faisant partie, avec ladite bille et son ressort, des moyens de verrouillage de la vis.

De préférence encore, la tête d'entraînement de la vis sans fin a une forme telle qu'elle ne peut être entraînée par un outil standard, et l'ensemble est associé à un outil spécial pour entraîner ladite tête.
Avantageusement, l'outil spécial comprend un limiteur de couple.

L'invention va maintenant être décrite de façon plus détaillée à l'aide d'exemples pratiques, illustrés avec les figures, parmi lesquelles :
Figure 1 est une vue en perspective éclatée d'un dispositif conforme à l'art antérieur,
Figure 2 est une vue analogue du dispositif selon l'invention,
Figure 3 est une vue en perspective de la pièce de support de la vis sans fin et de la crémaillère,
Figure 4 est une coupe transversale selon la ligne IV-IV de la figure 3.
Figure 5 est une coupe transversale selon la ligne V-V de la figure 3.

On notera que, sur les figures, le boîtier est représenté comme horizontal, avec le dispositif de verrouillage porté par le fond. Il est cependant possible de disposer le boîtier autrement, par exemple incliné ou avec le dispositif de verrouillage placé, par exemple, sur une paroi latérale du boîtier. Les mots "base", "fond", "face verticale", etc.. ne sont employés dans ce texte qu'à titre indicatif.

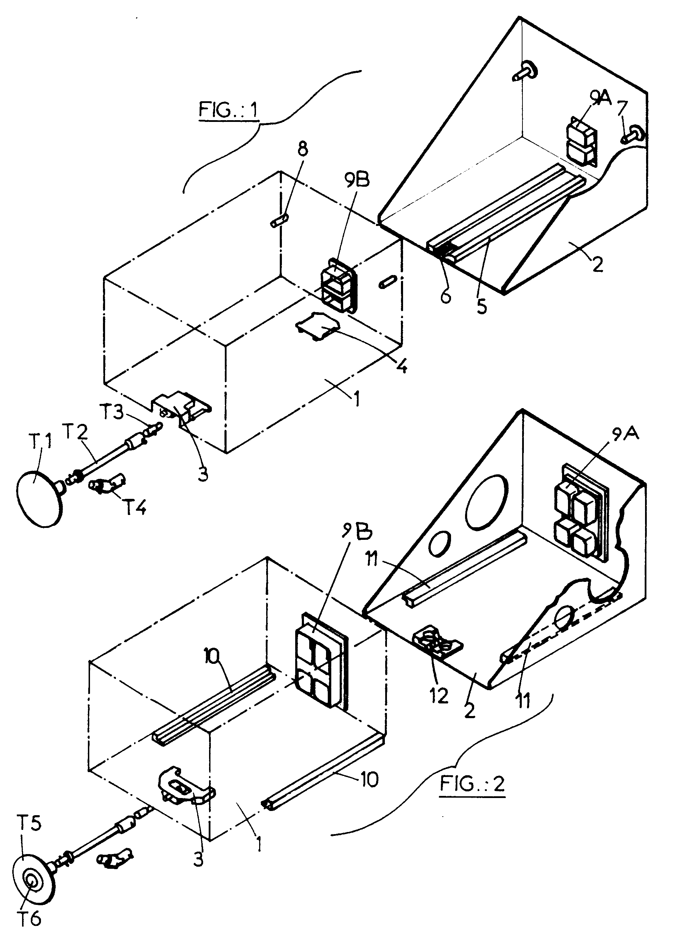

La figure 1 montre un boîtier 1, représenté en traits mixtes pour une meilleure lisibilité, et son logement 2, représenté partiellement arraché. Le repère 3 désigne un support de vis sans fin, porté par la base du boîtier 1. Le repère 4 désigne une pièce de guidage portée également par la base du boîtier 1, mais à l'opposé, axialement, de la pièce 3.

Le logement 2 porte une glissière formée de deux rails 5, situés dans la partie médiane de son fond, et solidaires d'une crémaillère 6, destinée à coopérer avec la vis sans fin portée par le support 3. La glissière 5 coopère avec des surfaces correspondantes portées par la pièce 3 et par la pièce de guidage 4. Des tétons de guidage supplémentaires 7 portés par la face verticale du logement 2 qui est opposée à son entrée, sont destinés à coopérer avec des tubes de guidage 8 portés par la face correspondante du boîtier.

On a représenté en 9A, 9B deux parties d'un connecteur électrique à fiches multiples, portées respectivement par le logement 2 et par le boîtier 1. On a représenté en T1 un outil d'entraînement de la vis sans fin, avec deux rallonges interchangeables T2, T3, et un raccord à cardan T4, qui peut se substituer ou s'ajouter aux rallonges T2 et T3.

Pour mettre en place le boîtier dans son logement, on l'engage jusqu'à amener la pièce de guidage 4 en correspondance avec la glissière 5, puis on pousse le boîtier pour le faire coulisser le long de la glissière, jusqu'à ce que la pièce-support de vis sans fin 3 coopère à son tour avec la glissière. Pour terminer la mise en place, on utilise l'outil T1 qui, en faisant tourner la vis sans fin coopérant avec la crémaillère 6, amène le boîtier dans sa position finale. Un système de verrouillage, non visible sur la figure, empêche une rotation intempestive de la vis sans fin, qui aboutirait à un déplacement du boîtier. Pour retirer le boîtier, on utilise l'outil T1 de façon à faire parcourir au boîtier la faible distance correspondant à la séparation des parties 9A et 9B du connecteur, laquelle exige une force importante. Après cela, on peut continuer à la main à sortir le boîtier.

Sur la figure 2, les mêmes éléments portent les mêmes repères.

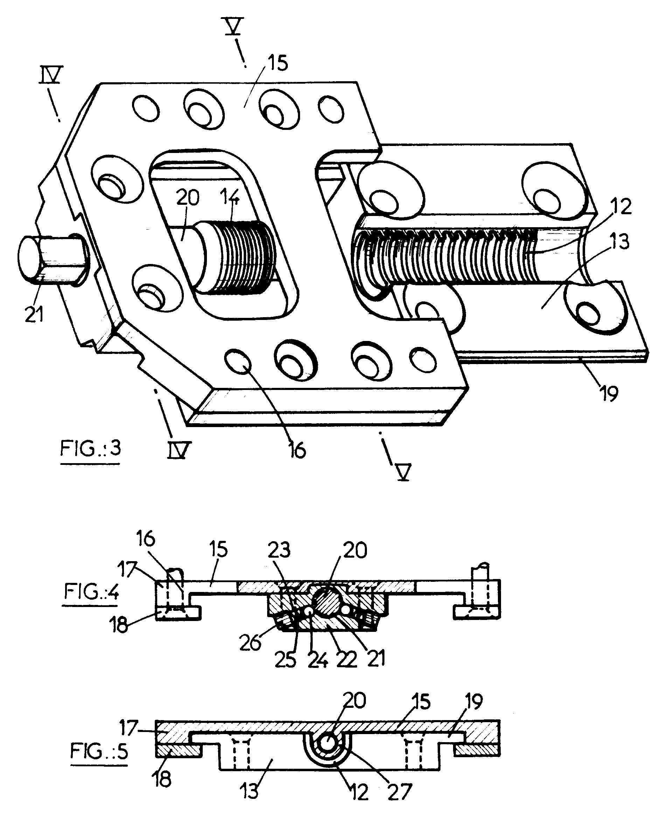

On constate que le boîtier 1 porte une pièce de verrouillage 3 de forme différente de celle qu'on voit à la figure 1. Cette pièce, qui est plus étalée et plus plate, donc moins encombrante, est illustrée de façon plus détaillée sur les figures 3 et 4. Vers ses arêtes longitudinales, le boîtier porte deux coulisses 10, conçues pour coopérer avec des glissières 11 prévues sur le fond du boîtier. Il n'existe plus de pièce de guidage 4. La pièce portant la crémaillère 12 est donc indépendante des glissières 11.

Les figures 3 et 4 montrent le détail de la pièce 3 portant la vis sans fin, et de la pièce 13 portant la crémaillère 12. Sur la figure 3, ces deux pièces sont montrées en position d'engagement partiel, la vis sans fin 14 étant cependant écartée de la crémaillère 12. La pièce 3 comporte une plaque 15, pourvue de trous 16 pour sa fixation sur la face inférieure du boîtier. Sur ses bords latéraux, la plaque 15 porte une surépaisseur 17, sur laquelle est fixée une plaque 18, un peu plus large, et qui constitue avec la plaque 15 une rainure dans laquelle vient s'engager le bord 19 de la pièce 13, de façon à obtenir une bonne coopération de la vis sans fin 14 et de la crémaillère 12.

Dans une variante encore plus simple et plus légère, la plaque 15, la surépaisseur 17 et la plaque 18 constituent une pièce unique.

Avantageusement, les trous de fixation 16 traversent la surépaisseur 17 et la plaque 18 pour éviter une déformation de la plaque 15.

La vis sans fin 14 est solidaire d'une tige 20 terminée par une tête d'entraînement 21. Cette tête est de forme spéciale, c'est-à-dire qu'elle ne peut pas être actionnée par une clef six-pans standard. Elle a, par exemple, une section polygonale non régulière. L'outil d'entraînement T5 a, bien entendu, une forme adaptée. En outre, il contient un limiteur de couple incorporé T6. De cette façon l'enlèvement du boîtier 1 est rendu impossible pour une personne non autorisée, et le boîtier ne peut souffrir d'efforts exagérés, susceptibles d'endommager notamment le connecteur 9a, 9B.

Le mécanisme de verrouillage est lisible à la figure 4. La tige 20 comporte, sur une partie de sa longueur, des cannelures 21, et sur autre partie de sa longueur, une portée lisse. Une pièce de support rapportée 22 est traversée par un alésage servant de palier pour la tige 20 sur une partie de sa longueur. Cette pièce est traversée, dans l'autre partie de son alésage, de deux alésages transversaux 23, dans chacun desquels peut se déplacer une bille 24 poussée par un ressort 25, maintenu par vis 26.

Les deux alésages 23 forment un angle tel que, selon la position angulaire de la tige 20, l'une ou l'autre des billes s'engage dans une cannelure.

La figure 5 montre l'extrémité de la tige 20, maintenue par un palier 27, solidaire de la plaque 15.

Comme on peut le constater, l'ensemble d'actionnement et de verrouillage est d'une grande simplicité, et d'un encombrement considérablement réduit par rapport à l'art antérieur.

## Revendications

1. Ensemble démontable de matériel électrique ou électronique, comprenant :
- un boîtier (1) contenant des éléments électriques ou électroniques,
- un logement (2) apte à recevoir ledit boîtier et pourvu de glissières (11) aptes à coopérer avec des pièces de guidage complémentaires (10) portées par le boîtier pour l'introduction ou l'extraction de ce dernier,
- au moins un connecteur à fiches constitué de deux éléments prévus l'un (9B) sur le boîtier et l'autre (9A) sur le logement, et qui sont en connexion lorsque le boîtier est complètement engagé dans le logement,
- des organes de serrage et d'extraction aptes à permettre de déplacer le boîtier au voisinage de sa position d'engagement complet en surmontant les forces de frottement engendrées par le connecteur, ces organes de serrage et d'extraction comprenant une vis sans fin (14) portée par le boîtier et une crémaillère correspondante (12) portée par le logement, et
- des moyens pour bloquer la rotation de ladite vis sans fin et immobiliser ainsi le boîtier en position d'engagement complet,
caractérisé en ce que lesdites glissières (11) portées par le logement sont indépendantes de la crémaillère (12) et espacées de celle-ci, et les pièces de guidage (10) complémentaires liées au boîtier sont espacées l'une de l'autre dans une direction perpendiculaire à la direction d'introduction ou d'extraction du boîtier.

2. Ensemble selon la revendication 1, dans lequel le boîtier et son logement sont en forme de parallélépipède, caractérisé en ce que les pièces de guidage (10) portées par le boîtier (1) sont situées à proximité des arêtes de la face dudit boîtier qui porte des organes de serrage et d'extraction.

3. Ensemble selon la revendication 1 ou 2, caractérisé en ce qu'il est prévu des moyens de guidage (17, 18, 19) indépendants desdites pièces de guidage et glissières, ces moyens étant situés à proximité de la vis sans fin et de la crémaillère et servant uniquement à faciliter l'engagement de ces pièces entre-elles lorsque le boîtier parvient au voisinage de sa position d'engagement complet dans le logement.

4. Ensemble selon l'une des revendications 1 à 3, dans lequel la vis sans fin (14) peut être entraînée en rotation par une tige (20) pourvue d'une tête d'entraînement (21) destinée à coopérer avec un outil, caractérisé en ce que la vis sans fin est d'une seule pièce avec ladite tige et sa tête d'entraînement, et en ce qu'elle est maintenue sur un support (3) lié au boîtier à l'aide de deux paliers (22, 27) dont l'un au moins est rapporté.

5. Ensemble selon la revendication 4, caractérisé en ce que ladite tige comporte des cannelures (21) ou des crantages destinés à coopérer avec au moins une bille (24), poussée par un ressort (25), ces cannelures ou crantages faisant partie, avec ladite bille et son ressort, des moyens de blocage de la vis sans fin.

6. Ensemble selon l'une des revendications 1 à 5 et dans lequel la vis sans fin (14) peut être entraînée en rotation par une tige (20) pourvue d'une tête d'entraînement (21) destinée à coopérer avec un outil, caractérisé en ce que la tête d'entraînement de la vis sans fin a une forme telle qu'elle ne peut être entraînée par un outil standard, et l'ensemble est associé à un outil spécial (T5) pour entraîner ladite tête (21).

7. Ensemble selon la revendication 6, caractérisé en ce que l'outil spécial (T5) comprend un limiteur de couple (T6).

## Claims

1. A removable electrical or electronic equipment assembly comprising :
- a box (1) containing electrical or electronic elements,
- a housing (2) capable of receiving the said box and equipped with guide pieces designed to interact with matching guide pieces (10) carried by the box for the insertion or extraction of the latter,
- at least one plug connector composed of two elements which are provided one (9B) on the box and the other (9A) on the housing and which are in connection when the box is completely engaged in the housing,
- clamping and extracting members capable of making it possible to move the box into the vicinity of its position of complete engagement by overcoming the frictional forces generated by the connector, these clamping and extracting members comprising an endless screw (14) carried by the box and a corresponding rack (12) carried by the housing, and
- means for blocking the rotation of the said endless screw and thereby immobilizing the box in the position of complete engagement,
characterized in that the said guide pieces (11) carried by the housing are independent of the rack (12) and spaced from this, and the matching guide pieces (10) connected to the box are spaced one from the other in a direction which is perpendicular to the direction of introduction or extraction of the box.

2. The assembly as claimed in claim 1, wherein the box and its housing are parallelepipedic, characterized in that the guide pieces (10) carried by the box (1) are located near the edges of the face of the said box carrying clamping and extracting members.

3. The assembly as claimed in claim 1 or 2, further comprising guide means (17, 18, 19) independent of said guide pieces, these means being located near the endless screw and the rack and serving only to make it easier to engage these pieces with one another when the box comes into the vicinity of its position of complete engagement in the housing.

4. The assembly as claimed in one of the claims 1 to 3, wherein the endless screw (14) can be driven in rotation by a rod (20) equipped with a drive head (21) intended for interacting with a tool, wherein the endless screw is in one piece with the said rod and its drive head, and wherein it is retained on a support (3) connected to the box by means of two bearings (22, 27), at least one of which is attached.

5. The assembly as claimed in claim 4, wherein said rod has grooves (21) or serrations intended for interacting with at least one ball (24) pushed by a spring (25), these grooves or serrations forming, with said ball and its spring, part of the means for blocking the endless screw.

6. The assembly as claimed in one of the claims 1 to 5, wherein the endless screw (14) can be driven in rotation by a rod (20) equipped with a drive head (21), intended for interacting with a tool, characterized in that the drive head of the endless screw is of such a form that it cannot be driven by a standard tool, and the assembly is associated with a special tool (T5) for driving the said head (21).

7. The assembly as claimed in claim 6, wherein said special tool (T5) possesses a torque limiter (T6).

## Patentansprüche

1. Lösbare Baugruppe für eine elektrische oder elektronische Anlage, mit
- einem Gehäuse (1), welches elektrische oder elektronische Element enthält,
- einer Aufnahme (2), die geeignet ist, das Gehäuse aufzunehmen und mit Führungen (11) versehen ist, die geeignet sind, mit komplementären Führungsteilen (10) zusammenzuarbeiten, die von dem Gehäuse zum Einführen oder Herausziehen des letzteren getragen sind,
- zumindest einem Steckverbinder, der von zwei Elementen gebildet ist, wovon das eine (9B) auf dem Gehäuse und das andere (9A) auf der Aufnahme vorgesehen ist, und die in Verbindung sind, wenn das Gehäuse vollständig in die Aufnahme eingefügt ist,
- Organen zum Befestigen und zum Herausziehen, die geeignet sind, zu erlauben, daß das Gehäuse in der Nachbarschaft seiner vollständigen Einfügungsposition verschoben wird, indem die von dem Steckverbinder verursachten Reibungskräfte überstiegen werden, wobei die Organe zum Befestigen und zum Herausziehen eine Endlosschraube (14) aufweisen, die von dem Gehäuse getragen ist und eine entsprechende Zahnstange (12), die von der Aufnahme getragen ist, und
- Mitteln zum Blockieren der Drehung der Endlosschraube und damit Festhalten des Gehäuses in vollständiger Einfügeposition,
dadurch gekennzeichnet, daß die von der Aufnahme getragenen Führungen (11) unabhängig von der Zahnstange (12) und von dieser beabstandet sind, und die entsprechenden Führungsteile (10), die mit dem Gehäuse verbunden sind, voneinander in einer Richtung senkrecht zur Richtung des Einführens oder Herausziehens des Gehäuses beabstandet sind.

2. Baugruppe gemäß Anspruch 1, in der das Gehäuse und seine Aufnahme von parallelepipedischer Form sind, dadurch gekennzeichnet, daß die Führungsteile (10), die von dem Gehäuse (1) getragen sind, in der Nähe der Ränder der Seite des Gehäuses angeordnet sind, die die Organe zum Befestigen und zum Herausziehen trägt.

3. Baugruppe gemäß Anspruch 1 oder 2, dadurch gekennzeichnet, daß sie mit Mitteln zum Führen (17, 18, 19) unabhängig von den Führungsteilen und Führungen versehen ist, wobei diese Mittel in der Nähe der Endlosschraube und der Zahnstange vorgesehen sind und einzig dazu dienen, die Mitwirkung dieser Teile zu erleichtern, wenn das Gehäuse in Nachbarschaft seiner vollständigen Einfügeposition in der Aufnahme gelangt.

4. Baugruppe gemäß einem der Ansprüche 1 bis 3, in der die Endlosschraube (14) von einem Schaft (20) in Drehung angetrieben werden kann, der mit einem Mitnahmekopf (21) versehen ist, der dazu bestimmt ist, mit einem Werkzeug zusammenzuarbeiten, dadurch gekennzeichnet, daß die Endlosschraube einstückig mit dem Zapfen und seinem Mitnahmekopf ist, und daß sie auf einem Träger (3) gehalten ist, der mit dem Gehäuse mit Hilfe von zwei Lagern (22, 27) gehalten ist, wovon zumindest das eine angesetzt ist.

5. Baugruppe gemäß Anspruch 4, dadurch gekennzeichnet, daß der Zapfen Längsnuten (21) oder Rastungen aufweist, die dazu bestimmt sind, mit zumindest einer Kugel (24) zusammenzuarbeiten, die von einer Feder (25) gedrückt wird, wobei die Längsnuten oder Rastungen mit der Kugel und ihrer Feder Teile von Mitteln zum Blockieren der Endlosschraube bilden.

6. Baugruppe gemäß einem der Ansprüche 1 bis 5 und bei der die Endlosschraube (14) in Drehung von einem Schaft (20) angetrieben werden kann, der mit einem Mitnahmekopf (21) versehen ist, der bestimmt ist, mit einem Werkzeug zusammenzuarbeiten, dadurch gekennzeichnet, daß der Mitnahmekopf der Endlosschraube eine Form hat, so daß er nicht von einem Standardwerkzeug angetrieben werden kann, und die Baugruppe einem Spezialwerkzeug (T5) zugeordnet ist, um den Kopf (21) anzutreiben.

7. Baugruppe gemäß Anspruch 6, dadurch gekennzeichnet, daß das Spezialwerkzeug (T5) einen Drehmomentenbegrenzer (T6) aufweist.
